# EUROPÄISCHE PATENTANMELDUNG

(11) **EP 2 161 974 A1**
(43) Veröffentlichungstag der Anmeldung: **10.03.2010**
(21) Anmeldenummer: 08163952.8
(22) Anmeldetag: 09.09.2008
(51) Int. Cl.: H05K 3/28

(54) **Bifunktionale EMV Beschichtung**

(71) Anmelder: Hegutechnik v. Gutwald KG, 90522 Oberasbach (DE)
(72) Erfinder: Wüst, Matthias, 90765 Fürth (DE)
(74) Vertreter: Götz, Georg Alois

(57) **Zusammenfassung**

Vorrichtung mit wenigstens einem elektronischen Bauteil, wobei die Vorrichtung wenigstens ein Mittel zur Gewährleistung oder Herstellung der elektromagnetischen Verträglichkeit aufweist und wobei die Vorrichtung als wenigstens ein Mittel zur Gewährleistung oder Herstellung der elektromagnetischen Verträglichkeit eine Polymerbeschichtung, insbesondere mit Parylene und/oder einem paryleneähnlichen Material, aufweist, auf der eine leitende Deckschicht aufgetragen ist.

## Beschreibung

Die Erfindung betrifft eine Vorrichtung mit wenigstens einem elektronischen Bauteil, wobei die Vorrichtung wenigstens ein Mittel zur Gewährleistung oder Herstellung der elektromagnetischen Verträglichkeit aufweist, sowie ein zugehöriges Verfahren zur Gewährleistung oder Herstellung der elektromagnetischen Verträglichkeit einer Vorrichtung mit wenigstens einem elektronischen Bauteil.

Mit dem Stichwort "elektromagnetische Verträglichkeit" (im Folgenden auch kurz EMV) wird in der Technik das Problem bzw. der Wunsch beschrieben, dass technische Geräte einander nicht wechselseitig durch ungewollte elektrische bzw. elektromagnetische Effekte störend beeinflussen sollten. Entsprechende elektrische bzw. elektronische Geräte sollten also in der Lage sein, in ihrem Umfeld zufriedenstellend zu arbeiten, ohne dabei ihrerseits elektromagnetische Störungen hervorzurufen, die für in dem Umfeld des jeweiligen Gerätes vorhandene andere Geräte oder Systeme problematisch bzw. nicht mehr akzeptabel wären.

Zur Herstellung bzw. Gewährleistung der geforderten elektromagnetischen Verträglichkeit werden bisher meist aufwendige Techniken eingesetzt, bei denen Schutzgehäuse bzw. separate Abschirmungen in Form von mechanischen Schutzteilen und dergleichen zum Einsatz kommen.

Daneben gibt es heute im Stand der Technik bereits einige Ansätze, bei denen zumindest auf separate Schutzgehäuse verzichtet wird bzw. eine bessere Integration des EMV-Schutzes angestrebt wird.

Beispielsweise ist aus der Druckschrift WO 00/30418 zur elektromagnetischen Abschirmung von Leiterplatten ein Carbonbeschichtungsverfahren bekannt, bei dem eine Farbschicht, die hoch leitfähiges Carbon enthält, unter Vermittlung einer Isolationsabdeckung als separatem Bauteil auf eine Leiterplatte aufgebracht wird. Für diese EMV-Abschirmung ist aber eine separate Isolationsabdeckung erforderlich, mit der die Leiterplatte einfach bzw. zweifach abgedeckt wird, wobei bei einfacher Abdeckung eine weitere Isolationsbeschichtung aufgebracht wird. Die Eigenschaften des Isolationsmaterials der WO 00/30418 bleiben unspezifiziert.

Bei der Schutzstruktur für Halbleitersensoren der DE 10 2006 052 863 A1 ist vorgesehen, eine Metall-Isolator-Halbleiterstruktur auf dem gleichen Substrat oder Die zu integrieren, wobei die spezifische Ausbildung dieser sehr speziellen Schutzstruktur nicht weiter im Detail dargestellt ist.

Aus der DE 602 00 279 T2 ist eine Epoxidharzzusammensetzung zum Verkapseln von Halbleiterbauteilen bekannt. Das Einkapselungsmaterial der DE 602 00 279 T2 kann eine Abschirmfunktion für elektromagnetische Wellen haben. Zu diesem Zweck ist eine zweite Einkapselungsharzschicht vorgesehen, die spezielle konjungierte, anorganische Teilchen enthält, deren Oberflächen einer Beschichtungsbehandlung mit einem isolierenden anorganischen Material unterworfen sind.

Als weitere Dokumente zum Stand der Technik hinsichtlich elektromagnetischer Abschirmungen sind beispielsweise die DE 195 44 345 C1, die DE 199 02 188 A1 sowie die DE 696 31 162 T2 zu nennen.

Bei den bekannten Lösungen wird jedoch die Wahl des Materials nicht weiter spezifiziert bzw. diese weisen einen Aufbau auf, der nur eine Teillösung für bestimmte Bereiche eines technischen Gerätes bzw. einer elektronischen Baugruppe darstellt, das Aufbringen separater Elemente erfordert bzw., wie beispielsweise bei der Integration der EMV-Funktion in ein Einkapselungsmaterial, auf sehr spezielle Anwendungen zugeschnitten ist.

Der Erfindung liegt damit die Aufgabe zugrunde, eine diesbezüglich verbesserte Vorrichtung sowie ein entsprechend verbessertes zugehöriges Verfahren anzugeben.

Zur Lösung dieser Aufgabe ist eine Vorrichtung mit wenigstens einem elektronischen Bauteil vorgesehen, wobei die Vorrichtung wenigstens ein Mittel zur Gewährleistung oder Herstellung der elektromagnetischen Verträglichkeit aufweist und sich dadurch auszeichnet, dass sie als wenigstens ein Mittel zur Gewährleistung oder Herstellung der elektromagnetischen Verträglichkeit eine Polymerbeschichtung, insbesondere mit Parylene und/oder einem paryleneähnlichen Material, aufweist, auf der eine leitende Deckschicht aufgetragen ist.

Bei der erfindungsgemäßen Vorrichtung bzw. EMV-Abschirmung wird somit zunächst eine Polymerbeschichtung direkt auf das zu schützende Material bzw. die zu schützende Leiterplatte, ein Substrat oder dergleichen aufgetragen, auf welche erste Schicht anschließend eine zweite, leitende Schicht aufgebracht wird, um auf diese Art und Weise die bisherige aufwendige Technik der EMV-Abschirmungen, die von Schutzgehäusen bzw. separaten Abschirmungen ausgeht, zu ersetzen. Damit ist es möglich, EMV-Abschirmungen nicht nur zu verbessern, sondern auch die für diese erforderlichen Kosten zu senken, da aufwendige mechanische Schutzteile entfallen.

Vorzugsweise ist die zunächst bzw. zu unterst auf die Vorrichtung aufgebrachte Polymerbeschichtung durch direktes Abscheiden auf die entsprechende Vorrichtungsoberfläche, beispielsweise eine Leiterplattenoberfläche, und deren Bauteile entstanden. Dabei werden vorteilhafterweise die positiven Eigenschaften von Polymeren wie insbesondere Parylene bzw. paryleneähnlichen Materialien genutzt, beispielsweise deren Fähigkeit zum quasi porenfreien Abschluss, die Homogenität und natürlich die isolierenden Eigenschaften, die im Zusammenhang mit der leitenden Deckschicht den geforderten EMV-Schutz gewährleisten.

Die Polymerbeschichtung kann im Rahmen der Erfindung einheitlich aus Parylene bestehen bzw. aus einem Material mit ähnlichen Eigenschaften. Es kann sich aber auch um eine Polymerbeschichtung mit mehreren unterschiedlichen Bestandteilen, beispielsweise mit mehreren Polymerschichten oder mehreren -schichtabschnitten bzw. eine Struktur aus verschiedenen Materialien, handeln.

Durch die Überzugsschicht bzw. Leit- oder Deckschicht wird bei entsprechender vollständiger Auftragung für die gesamte Vorrichtung, also beispielsweise eine komplette Leiterplatte inklusive der Bauteile, mit denen diese bestückt ist, ein Schutz vor elektromagnetischen Störfeldern erreicht. Separate Schutzbauteile wie Gehäuse oder mechanische Abschirmungen sind nicht mehr erforderlich.

Die erfindungsgemäße Vorrichtung kann eine Leiterplatte oder ein Substrat oder ein zu schützendes Material oder Gerät oder eine Baugruppe sein oder die Vorrichtung kann wenigstens eine Leiterplatte und/oder wenigstens ein Substrat und/oder wenigstens ein zu schützendes Material und/oder Gerät und/oder wenigstens eine zu schützende Baugruppe umfassen.

Die Vorrichtung, die als elektrische bzw. elektronische Vorrichtung ein oder mehrere elektronische Bauteile aufweist, ist also beispielsweise eine Leiterplatte oder ein Substrat. Daneben kann es sich allgemein um Vorrichtungen aus mehreren bzw. verschiedenen Komponenten handeln, die beispielsweise als elektronisches Gerät eine Leiterplatte und/oder ein Substrat oder separate diverse Baugruppen aufweisen. Der erfindungsgemäße EMV-Schutz ist für unterschiedlichste Anwendungen, also beispielsweise nicht nur für Leiterplatten, sondern allgemein für elektronische Baugruppen oder dergleichen, geeignet. Entsprechend weit ist der Bereich der Vorrichtung, die von der Erfindung umfasst werden.

Die Polymerbeschichtung kann sich über den gesamten Oberflächenbereich der Vorrichtung oder über den gesamten Bereich wenigstens einer Oberfläche der Vorrichtung, der wenigstens ein elektronisches Bauteil zugeordnet ist, erstrecken, insbesondere auch über wenigstens ein elektronisches Bauteil der Vorrichtung, oder die Polymerbeschichtung kann partiell wenigstens einen Bereich einer Oberfläche, insbesondere mit wenigstens einem elektronischen Bauteil, der Vorrichtung abdecken.

Es besteht also die Möglichkeit, dass die Polymerschicht komplett beispielsweise über die Leiterplatte oder das Substrat aufgetragen ist, so dass nicht nur ein Bereich oder Bauteil der elektronischen bzw. technischen Vorrichtung geschützt ist, sondern diese insgesamt. Insbesondere kann die Polymerbeschichtung auf einer Oberseite und der Unterseite sowie auf den seitlichen Oberflächen einer Leiterplatte oder dergleichen aufgetragen sein, diese also insgesamt umgeben. Daneben besteht selbstverständlich die Möglichkeit, dass eine solche Polymerschicht, beispielsweise aus Parylene, nur auf einer oberen Oberfläche bzw. Oberseite aufgetragen ist, sofern diese die elektronischen Bauteile oder zumindest ein elektronisches Bauteil aufweist bzw. dieser entsprechende Bauteile, gegebenenfalls auch nicht direkt an der Oberfläche, zuzuordnen sind. Dabei erstreckt sich die Schicht vorzugsweise (direkt oder, falls die Bauteile ihrerseits beispielsweise nochmals abgedeckt oder eingekapselt sind, indirekt) über das oder die elektronischen Bauteile.

Die Beschichtung aus dem Polymer und dem über dem Polymer aufgetragenen Leitlack bzw. der leitenden Deckschicht kann allerdings auch eine partielle Beschichtung sein, also eine Schicht, die nur bestimmte besonders zu schützende Bereiche oder dergleichen bzw. einen oder mehrere Teile der Oberfläche eines zu schützenden Materials oder Substrats usw. abdeckt.

Die Polymerbeschichtung kann eine Dicke im Bereich von, zumindest im Wesentlichen, 1 Mikrometer bis 30 Mikrometern (1 - 30 µm) aufweisen. Dabei können selbstverständlich auch Schichtdicken im Zwischenbereich, also beispielsweise Schichtdicken von etwa 5 Mikrometern bzw. etwa 10 oder 20 Mikrometern verwendet werden, je nach der erforderlichen Isolationswirkung bzw. den sonstigen gewünschten Schichteigenschaften. Unter Umständen kann die Schichtdicke auch unter einem Mikrometer bzw. über 30 Mikrometern liegen. Der Bereich von 1 Mikrometer bis 20 Mikrometern ist bei der Verwendung von Parylene besonders geeignet, um die gewünschten elektrisch isolierenden Eigenschaften zu erreichen.

Die Polymerbeschichtung kann homogen und/oder antibakteriell und/oder elektrisch isolierend und/oder porenfrei und/oder eine gegen Umwelteinflüsse, insbesondere gegen hohe Luftfeuchtigkeit und/oder Schadstoffeinwirkungen und/oder Korrosion, schützende Beschichtung und/oder eine die Vorrichtung hermetisch abschließende Beschichtung sein.

Dabei ist zur Herstellung des EMV-Schutzes selbstverständlich eine gewisse elektrische Isolierwirkung ohnehin erforderlich. Die Verwendung von Parylene als Polymerbeschichtung hat nun den Vorteil, dass hiermit besonders hervorragende elektrisch isolierende Eigenschaften realisiert werden können, beispielsweise eine Durchschlagsfestigkeit im Bereich von etwa 5.500 bis 7.000 Volt/25,4 Mikrometern (5.500 bis 7.000 Volt/mil), in Abhängigkeit vom jeweils verwendeten Parylenetyp bzw. vom jeweils verwendeten paryleneähnlichen Material. Die Paryleneschicht hat als homogene Schicht den Vorteil, dass das Substrat bzw. ein anderes zu schützendes Bauteil wie eine Leiterplatte oder dergleichen zuverlässig gegenüber Umwelteinflüssen wie beispielsweise eine hohen Luftfeuchtigkeit oder Schadstoffeinwirkungen geschützt werden können, da mit Parylene eine porenfreie bzw. quasi porenfreie Schicht geschaffen wird, die das Substrat, die Leiterplatte oder dergleichen hermetisch einschließt. Daneben ist die Paryleneschicht eine antibakterielle Schicht, die Korrosionen und Beschädigungen der Leiterplatte bzw. des Substrats verhindert.

So wird insgesamt mit Hilfe der Polymerbeschichtung und der zugehörigen Deckschicht eine bifunktionale EMV-Beschichtung realisiert, die als EMV-Beschichtung nicht nur gegenüber elektromagnetischen Störungen schützt bzw. die elektromagnetische Verträglichkeit gewährleistet, sondern zudem einen zuverlässigen Schutz gegenüber Umwelt- bzw. Umfeldeinflüssen darstellt. Die erfindungsgemäße EMV-Beschichtung erfüllt in diesem Sinne mehrere Funktionen, die sich grob in die zwei Bereiche der EMV-Schutzfunktion und des Schutzes gegenüber Umwelteinflüssen aufteilen lassen.

Durch das Aufbringen einer leitenden Deckschicht auf die Parylenebeschichtung bzw. Polymerbeschichtung wird schließlich in Verbindung mit der Isolationswirkung der Polymerbeschichtung je nach Anforderungen ein kompletter EMV-Schutz bzw. ein partieller EMV-Schutz für gewisse Bereiche erzielt.

Die leitende Deckschicht kann die Polymerbeschichtung vollständig oder partiell, gegebenenfalls als partielle Beschichtung in mehreren Bereichen, abdecken bzw. überdecken und/oder es kann durch die Polymerbeschichtung und die leitende Deckschicht eine bifunktionale Beschichtung mit der Funktion der Gewährleistung oder Herstellung der elektromagnetischen Verträglichkeit und der Funktion des Schutzes gegen Umwelteinflüsse gegeben sein.

Die Polymerbeschichtung mit der über diese aufgetragenen Deckschicht aus Leitlack oder einem anderen geeigneten Material kann also beispielsweise eine Leiterplatte vollständig oder komplett überziehen, andererseits ist es ebenso denkbar, dass die Polymerbeschichtung lediglich eine partielle Beschichtung in einem bestimmten Bereich oder in mehreren Bereichen, insbesondere in Bereichen mit Bauteilen des Substrats oder der Leiterplatte usw., ist bzw. dass der Leitlack nur in bestimmten Bereichen auf die Polymerschicht aufgetragen ist.

Durch den Leitlack bzw. die leitende Deckschicht wird dabei der EMV-Schutz komplettiert, während andererseits, vorrangig durch die Polymerbeschichtung, ein Schutz gegenüber von außen kommenden Einflüssen gegeben ist.

Darüber hinaus ist es möglich, dass auf der leitenden Deckschicht eine weitere Polymerbeschichtung, insbesondere mit Parylene und/oder einem paryleneähnlichen Material und/oder mehreren Materialien, vorgesehen ist. Diese weitere Polymerbeschichtung kann insbesondere zum hermetischen Schutz gegen Umwelteinflüsse und/oder Umweltmedien dienen. So kann insbesondere ein Schutz gegenüber aggressiven Materialien im Umfeld der Vorrichtung erreicht werden.

Die leitende Deckschicht kann eine Leitlackschicht und/oder eine Schicht mit wenigstens einem leitenden Material sein. Das bedeutet, dass gegebenenfalls auch eine Schicht mit mehreren Komponenten, also eine Schichtstruktur aus gegebenenfalls unterschiedlichen Schichtkomponenten bzw. Materialien und/oder Teilschichten verwendet werden kann. Insbesondere kann es sich um eine Schicht handeln, die, gegebenenfalls neben weiteren Materialien, leitende Materialien zur Herstellung der Leitfähigkeit enthält. Durch die Überzugsschicht aus bzw. mit einem leitenden Material kann die komplette Leiterplatte samt den darauf aufgebrachten Bauteilen vor elektromagnetischen Störfeldern geschützt werden.

Des Weiteren betrifft die Erfindung ein Verfahren zur Gewährleistung oder Herstellung der elektromagnetischen Verträglichkeit einer Vorrichtung mit wenigstens einem elektronischen Bauteil, insbesondere wie im Vorstehenden geschildert, welches Verfahren sich dadurch auszeichnet, dass die Vorrichtung zur Gewährleistung oder Herstellung der elektromagnetischen Verträglichkeit mit einer Polymerbeschichtung, insbesondere mit Parylene und/oder einem paryleneähnlichen Material, beschichtet wird, auf der eine leitende Deckschicht aufgetragen wird.

Die Erfindung betrifft also ein Verfahren, mit dem die EMV-Anforderungen für eine elektrische, elektronische bzw. technische Vorrichtung erfüllt oder hergestellt werden können, wobei das Verfahren vorsieht, dass die zu schützende Vorrichtung wie eine Leiterplatte oder ein Substrat zunächst mit einem Polymer beschichtet wird, woraufhin auf der Polymerschicht eine leitende Deckschicht, vorrangig als Leitlack, aufgetragen wird.

Vor dem Aufbringen der Polymerbeschichtung, insbesondere mit Parylene und/oder einem paryleneähnlichen Material, kann das entsprechende Ausgangsmolekül (für das zu bildende Polymer) mittels eines Verdampfers von einer Dimerform in eine Monomerform umgewandelt werden. Es wird also beispielsweise das Dimer, das die Ausgangsbasis für Parylene bildet, in ein Monomer umgewandelt. Dies geschieht vorzugsweise unter Verwendung einer geeigneten Verdampfungseinrichtung.

Die Polymerbeschichtung kann durch Polymerisation von Monomeren unter Vakuum auf der Vorrichtung abgeschieden wird. Aus den einzelnen Monomeren wird so das fertige Polymer gebildet. Das Parylenematerial wird somit im Rahmen der Polymerisation in der endgültigen Form des Polymers aus einzelnen Monomeren beispielsweise an der Leiterplattenoberfläche sowie deren bestückten Bauteilen abgeschieden. Die Aufbringung auf dem Substrat, der Leiterplatte oder einem anderen zu schützenden Material erfolgt in diesem Fall im Rahmen des Polymerisationsvorganges.

Des Weiteren kann die leitende Deckschicht, nach dem Beschichten der Vorrichtung mit der Polymerbeschichtung, mittels eines Sprühverfahrens und/oder Tauchverfahrens und/oder Lackierverfahrens, insbesondere eines manuellen Lackierverfahrens, und/oder eines Aufdampfverfahrens auf die Polymerbeschichtung aufgebracht werden.

Es gibt somit unterschiedliche Möglichkeiten, die leitende Deckschicht, bei der es sich beispielsweise um eine Leitlackschicht handeln kann, auf die Polymerbeschichtung, beispielsweise die Parylenebeschichtung, aufzutragen bzw. diese mit der Deckschicht zu beschichten.

So wird zunächst durch eine Polymerisation eine homogene Schicht hergestellt, die das Substrat gegenüber Umwelteinflüssen schützt, woraufhin im nächsten Schritt eine Überzugsschicht auf die Polymerschicht aufgebracht wird, die als leitende Schicht den Schutz der Leiterplatte, des Substrats usw. gegenüber elektromagnetischen Störfeldern komplettiert. Selbstverständlich können zum Aufbringen der leitenden Deckschicht verschiedene Verfahren nicht nur nebeneinander, sondern gegebenenfalls auch in Kombination verwendet werden, insbesondere bei einer Deckschicht, die aus mehreren Schichtkomponenten oder einer komplizierteren Schichtstruktur mit gegebenenfalls mehreren Materialien besteht.

Die Vorrichtung kann im Rahmen des erfindungsgemäßen Verfahrens mit einer Polymerbeschichtung mit einer Dicke im Bereich von, zumindest im Wesentlichen, 1 Mikrometer bis 30 Mikrometern beschichtet werden. Letztlich kommt es bei der Wahl der Schichtdicke darauf an, dass die Beschichtung mit Parylene oder einem vergleichbarem Material in einer solchen Dicke erfolgt, dass die geforderten elektrisch isolierenden Eigenschaften sowie die Eigenschaften hinsichtlich des Schutzes gegenüber Umwelteinflüssen gegeben sind. Hierzu kann gegebenenfalls auch eine Polymerbeschichtung zum Einsatz kommen, die in verschiedenen Bereichen der Vorrichtung, die bifunktional geschützt werden soll, je nach Bedarf unterschiedliche Dicken aufweist.

Die Vorrichtung kann über den gesamten Oberflächenbereich der Vorrichtung oder über den gesamten Bereich wenigstens einer Oberfläche der Vorrichtung, der wenigstens ein elektronisches Bauteil zugeordnet ist, mit der Polymerbeschichtung beschichtet werden, insbesondere auch über wenigstens ein elektronisches Bauteil der Vorrichtung, oder es kann partiell wenigstens ein Bereich einer Oberfläche, insbesondere mit wenigstens einem elektronischen Bauteil, der Vorrichtung mit der Polymerbeschichtung beschichtet werden.

Vorrangig findet eine Komplettbeschichtung statt, mit der nicht nur ein Bereich oder Bauteil der elektronischen Vorrichtung, beispielsweise einer Leiterplatte oder eines Substrats, geschützt wird, sondern die komplette Vorrichtung mit ihren Bauteilen gegenüber Umwelteinflüssen und elektrisch isolierend geschützt wird. Wie erwähnt ist es für bestimmte Anwendungen aber auch denkbar, dass nur ein partieller Überzug der Vorrichtung vorgenommen wird.

Wenn das Substrat an seiner Oberfläche komplett, also inklusive der sämtlichen hierauf aufgebrachten Bauteile, beispielsweise mit Parylene bedeckt wird, so bietet dies den Vorteil, dass ein hermetischer Einschluss in die Paryleneschicht gegeben ist, wobei die Paryleneschicht vorteilhafterweise porenfrei und antibakteriell ist, Korrosion verhindert und darüber hinaus eine Beschädigung des Substrats durch Umwelteinflüsse weitestgehend ausschließt. Durch eine leitende Deckschicht auf der Paryleneschicht wird dann beim erfindungsgemäßen Verfahren ein vorrangig kompletter EMV-Schutz hergestellt, bei einem partiellen Überzug der Paryleneschicht beispielsweise mit Leitlack zumindest ein entsprechender partieller Schutz.

Wichtig ist, dass beim erfindungsgemäßen Verfahren zur Erfüllung der EMV-Anforderungen bzw. zur Herstellung der erforderlichen oder gewünschten EMV-Eigenschaften auf separate Bauteile wie Schutzgehäuse und somit eine aufwendige Technik, beispielsweise mit separaten mechanischen Abschirmungen und dergleichen, verzichtet werden kann.

Die leitende Deckschicht kann die Polymerbeschichtung vollständig oder partiell, gegebenenfalls in mehreren Bereichen, überdeckend aufgebracht werden und/oder mit der Polymerbeschichtung und der leitenden Deckschicht kann eine bifunktionale Beschichtung mit der Funktion der Gewährleistung oder Herstellung der elektromagnetischen Verträglichkeit und der Funktion des Schutzes gegen Umwelteinflüsse aufgetragen werden. In einem weiteren Verfahrensschritt kann auf der leitenden Deckschicht, also vorzugsweise der Leitlackschicht, nochmals eine zweite Polymerbeschichtung, gegebenenfalls auch aus einem anderen Polymermaterial aufgetragen werden, um beispielsweise den Schutz gegenüber besonders aggressiven Umweltmedien oder Umwelteinflüssen zu verbessern. Mit dem erfindungsgemäßen Verfahren wird so ein bifunktioneller Schutz erreicht, also zum Einen ein elektromagnetischer Schutz bzw. ein Schutz gegenüber elektromagnetischen Störfeldern, zum Anderen ein Schutz gegenüber für ein Substrat oder eine Leiterplatte bzw. eine andere Vorrichtung gegebenenfalls schädlichen Einwirkungen, beispielsweise ungünstigen Umweltbedingungen wie einer ungünstigen Luftfeuchtigkeit, in der Umwelt befindlichen aggressiven Medien und dergleichen.

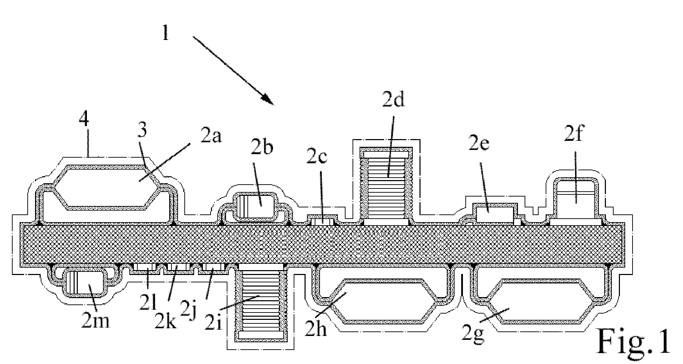

Weitere Vorteile, Merkmale und Einzelheiten der Erfindung ergeben sich anhand der folgenden Zeichnung sowie aus dem Ausführungsbeispiel. Dabei zeigt die Figur eine erfindungsgemäße Vorrichtung, deren EMV-Schutz nach einem erfindungsgemäßen Verfahren hergestellt wurde.

Die erfindungsgemäße Vorrichtung 1 ist im hier gezeigten Fall eine Leiterplatte, die mit diversen elektronischen Komponenten bzw. Bauteilen 2a - 2m bestückt ist.

Die erfindungsgemäße Vorrichtung 1 wurde im Rahmen eines erfindungsgemäßen Verfahrens zur Herstellung bzw. Gewährleistung der elektromagnetischen Verträglichkeit durch eine Polymerisationsreaktion mit einer Polymerbeschichtung 3 aus Parylene versehen, die in diesem Ausführungsbeispiel die komplette Leiterplatte bzw. die komplette Leiterplattenoberfläche abdeckt. Dies bedeutet, dass die Vorrichtung 1 in ihrer Gesamtheit, also inklusive aller ihrer Bauteile 2a - 2m, mit Parylene beschichtet ist, so dass die Leiterplatte hermetisch in die Paryleneschicht, die porenfrei und antibakteriell ist, eingeschlossen ist, wodurch nicht nur eine Korrosion ausgeschlossen wird, sondern zudem ein wirksamer Schutz der Leiterplatte und ihrer Bauteile 2a - 2m gegenüber Umwelteinflüssen gewährleistet ist.

Die Isolierschicht bzw. Polymerbeschichtung 3 aus Parylene hat im gezeigten Ausführungsbeispiel eine Dicke zwischen 0,001 Millimetern und 0,03 Millimetern. In anderen Ausführungsbeispielen können, beispielsweise wenn ein Schutz gegenüber besonders aggressiven Umweltmedien erreicht werden soll, auch dickere Schichten zum Einsatz kommen, während in anderen Fällen gegebenenfalls dünnere Schichten ausreichend sein können.

Über der Polymerschicht 3 aus Parylene, die elektrisch isolierend wirkt, ist ein Überzug aus leitendem Lack als leitende Deckschicht 4 vorgesehen, durch den in Verbindung mit der elektrisch isolierenden Polymerbeschcihtung 3 die gewünschte EMV-Abschirmung erreicht wird.

Die erfindungsgemäße Vorrichtung 1 ist somit bifunktional geschützt, weist also einen Schutz gegenüber elektromagnetischen Störfeldern einerseits auf, während andererseits schon durch die Verwendung des Polymermaterials ein Schutz gegenüber Umwelteinflüssen realisiert ist.

Um die Beschichtung mit der Polymerbeschichtung 3 zu erreichen, wird Parylene vom Dimer mittels eines Verdampfers in ein Monomer umgewandelt und unter Vakuum im Rahmen einer Polymerisation mit der gewünschten Schichtdicke an der Leiterplattenoberfläche abgeschieden. Parylene ist als Material besonders geeignet, da es hervorragende elektrisch isolierende Eigenschaften wie etwa, je nach Parylenetyp, eine Durchschlagsfestigkeit im Bereich von etwa 5.500 bis 7.000 Volt/25,4 Mikrometern (5.500 bis 7.000 Volt/mil) aufweist. Zudem wird durch Parylene ein Schutz gegenüber Umwelteinflüssen erreicht, da die homogene Paryleneschicht beispielsweise wirksam gegenüber hohen Luftfeuchtigkeiten und Schadstoffeinwirkungen schützen kann, wobei sie porenfrei die Leiterplatte bzw. die Vorrichtung 1 bedeckt.

In anderen Ausführungsbeispielen kann in Ergänzung zur Polymerschicht 3 oberhalb der leitenden Deckschicht 4 eine weitere Polymerbeschichtung bzw. Parylenebeschichtung vorgesehen sein, beispielsweise um einen zusätzlichen Schutz gegenüber Umweltmedien herzustellen. Darüber hinaus ermöglicht eine derartige zusätzliche Beschichtung die Montage mehrerer Baugruppen ohne die Einhaltung bzw. unter Veringerung von Kriech- bzw. Luftstrecken, d.h. es ist kein oder ein geringerer Abstand zwischen den Baugruppen für die Einhaltung der Hochspannungsfestigkeit notwendig.

Die leitende Deckschicht 4 ist vorliegend mittels eines Lackierverfahrens aufgebracht worden. Bei anderen Vorrichtungen vergleichbarer Art können ebenso andere Aufbringungsverfahren zum Einsatz kommen, beispielsweise Sprühverfahren, Tauchverfahren oder Aufdampfverfahren.

Insgesamt kann mit der erfindungsgemäßen Vorrichtung 1 bzw. dem zugehörigen Verfahren ein effektiver Schutz gegenüber elektromagnetischen Störfeldern und Umwelteinflüssen erreicht werden, ohne dass aufwendige Abschirmgehäuse bzw. mechanische EMV-Schutzmaßnahmen erforderlich wären. Dabei ist der Schutz gegenüber Umwelteinflüssen und gegen elektromagnetische Störfelder von einer hohen Qualität, wobei durch die Verwendung der Polymerbeschichtung bzw. der Paryleneschicht eine Reihe positiver Eigenschaften wie eine hohe Spannungsfestigkeit, der erwähnte Korrosionsschutz usw. erzielt werden können. So kann eine traditionelle und mit viel Aufwand verbundene Herstellung eines EMV-Schutzes durch ein vergleichsweise einfaches Verfahren ersetzt werden.

### Bezugszeichenliste

- 1: Vorrichtung
- 2a: -2m Elektronische Bauteile
- 3: Polymerbeschichtung
- 4: leitende Deckschicht

## Patentansprüche

1. Vorrichtung (1) mit wenigstens einem elektronischen Bauteil (2a - 2m), wobei die Vorrichtung (1) wenigstens ein Mittel zur Gewährleistung oder Herstellung der elektromagnetischen Verträglichkeit aufweist, **dadurch gekennzeichnet, dass** die Vorrichtung (1) als wenigstens ein Mittel zur Gewährleistung oder Herstellung der elektromagnetischen Verträglichkeit eine Polymerbeschichtung (3), insbesondere mit Parylene und/oder einem paryleneähnlichen Material, aufweist, auf der eine leitende Deckschicht (4) aufgetragen ist.

2. Vorrichtung (1) nach Anspruch 1, **dadurch gekennzeichnet, dass** die Vorrichtung (1) eine Leiterplatte oder ein Substrat oder ein zu schützendes Material oder Gerät oder eine Baugruppe ist oder dass die Vorrichtung (1) wenigstens eine Leiterplatte und/oder wenigstens ein Substrat und/oder wenigstens ein zu schützendes Material und/oder Gerät und/oder wenigstens eine zu schützende Baugruppe umfasst.

3. Vorrichtung (1) nach einem der vorangehenden Ansprüche, **dadurch gekennzeichnet, dass** die Polymerbeschichtung (3) sich über den gesamten Oberflächenbereich der Vorrichtung (1) oder über den gesamten Bereich wenigstens einer Oberfläche der Vorrichtung (1), der wenigstens ein elektronisches Bauteil (2a - 2m) zugeordnet ist, erstreckt, insbesondere auch über wenigstens ein elektronisches Bauteil (2a - 2m) der Vorrichtung (1), oder dass die Polymerbeschichtung (3) partiell wenigstens einen Bereich einer Oberfläche, insbesondere mit wenigstens einem elektronischen Bauteil (2a - 2m), der Vorrichtung (1) abdeckt.

4. Vorrichtung (1) nach einem der vorangehenden Ansprüche, **dadurch gekennzeichnet, dass** die Polymerbeschichtung (3) eine Dicke im Bereich von, zumindest im Wesentlichen, 1 µm bis 30 µm aufweist.

5. Vorrichtung (1) nach einem der vorangehenden Ansprüche, **dadurch gekennzeichnet, dass** die Polymerbeschichtung (3) homogen und/oder antibakteriell und/oder elektrisch isolierend und/oder porenfrei und/oder eine gegen Umwelteinflüsse, insbesondere gegen hohe Luftfeuchtigkeit und/oder Schadstoffeinwirkungen und/oder Korrosion, schützende Beschichtung und/oder eine die Vorrichtung (1) hermetisch abschließende Beschichtung ist.

6. Vorrichtung (1) nach einem der vorangehenden Ansprüche, **dadurch gekennzeichnet, dass** die leitende Deckschicht (4) die Polymerbeschichtung (3) vollständig oder partiell, gegebenenfalls in mehreren Bereichen, überdeckt und/oder dass durch die Polymerbeschichtung (3) und die leitende Deckschicht (4) eine bifunktionale Beschichtung mit der Funktion der Gewährleistung oder Herstellung der elektromagnetischen Verträglichkeit und der Funktion des Schutzes gegen Umwelteinflüsse gegeben ist.

7. Vorrichtung (1) nach einem der vorangehenden Ansprüche, **dadurch gekennzeichnet, dass** auf der leitenden Deckschicht (4) eine weitere Polymerbeschichtung, insbesondere mit Parylene und/oder einem paryleneähnlichen Material, vorgesehen ist, insbesondere zum hermetischen Schutz gegen Umwelteinflüsse und/oder Umweltmedien.

8. Vorrichtung (1) nach einem der vorangehenden Ansprüche, **dadurch gekennzeichnet, dass** die leitende Deckschicht (4) eine Leitlackschicht und/oder eine Schicht mit wenigstens einem leitenden Material ist.

9. Verfahren zur Gewährleistung oder Herstellung der elektromagnetischen Verträglichkeit einer Vorrichtung (1) mit wenigstens einem elektronischen Bauteil (2a - 2m), insbesondere nach einem der vorangehenden Ansprüche, **dadurch gekennzeichnet, dass** die Vorrichtung (1) zur Gewährleistung oder Herstellung der elektromagnetischen Verträglichkeit mit einer Polymerbeschichtung (3), insbesondere mit Parylene und/oder einem paryleneähnlichen Material, beschichtet wird, auf der eine leitende Deckschicht (4) aufgetragen wird.

10. Verfahren nach Anspruch 9, **dadurch gekennzeichnet, dass** vor dem Aufbringen der Polymerbeschichtung (3), insbesondere mit Parylene und/oder einem paryleneähnlichen Material, das entsprechende Ausgangsmolekül mittels eines Verdampfers von einer Dimerform in eine Monomerform umgewandelt wird.

11. Verfahren nach einem der Ansprüche 9 oder 10, **dadurch gekennzeichnet, dass** die Polymerbeschichtung (3) durch Polymerisation von Monomeren unter Vakuum auf der Vorrichtung (1) abgeschieden wird.

12. Verfahren nach einem der Ansprüche 9 bis 11, **dadurch gekennzeichnet, dass** die leitende Deckschicht (4), nach dem Beschichten der Vorrichtung (1) mit der Polymerbeschichtung (3), mittels eines Sprühverfahrens und/oder Tauchverfahrens und/oder Lackierverfahrens, insbesondere eines manuellen Lackierverfahrens, und/oder eines Aufdampfverfahrens auf die Polymerbeschichtung (3) aufgebracht wird.

13. Verfahren nach einem der Ansprüche 9 bis 12, **dadurch gekennzeichnet, dass** die Vorrichtung (1) mit einer Polymerbeschichtung (3) mit einer Dicke im Bereich von, zumindest im Wesentlichen, 1 µm bis 30 µm beschichtet wird.

14. Verfahren nach einem der Ansprüche 9 bis 13, **dadurch gekennzeichnet, dass** die Vorrichtung (1) über den gesamten Oberflächenbereich der Vorrichtung (1) oder über den gesamten Bereich wenigstens einer Oberfläche der Vorrichtung (1), der wenigstens ein elektronisches Bauteil (2a - 2m) zugeordnet ist, mit der Polymerbeschichtung (3) beschichtet wird, insbesondere auch über wenigstens ein elektronisches Bauteil (2a - 2m) der Vorrichtung, oder dass partiell wenigstens ein Bereich einer Oberfläche, insbesondere mit wenigstens einem elektronischen Bauteil (2a - 2m), der Vorrichtung (1) mit der Polymerbeschichtung (4) beschichtet wird.

15. Verfahren nach einem der Ansprüche 9 bis 14, **dadurch gekennzeichnet, dass** die leitende Deckschicht (4) die Polymerbeschichtung (3) vollständig oder partiell, gegebenenfalls in mehreren Bereichen, überdeckend aufgebracht wird und/oder dass mit der Polymerbeschichtung (3) und der leitenden Deckschicht (4) eine bifunktionale Beschichtung mit der Funktion der Gewährleistung oder Herstellung der elektromagnetischen Verträglichkeit und der Funktion des Schutzes gegen Umwelteinflüsse aufgetragen wird.
